# DEMANDE DE BREVET EUROPEEN

(11) **EP 0 788 139 A1**
(43) Date de publication de la demande: **06.08.1997**
(21) Numéro de dépôt: 97400216.4
(22) Date de dépôt: 30.01.1997
(51) Int. Cl.: H01J 37/34

(54) **Procédé et dispositif pour réaliser un dépôt par pulvérisation cathodique à partir d'une cible portée à haute température**

(30) Priorité: 02.02.1996 FR 9601268
(71) Demandeur: COMMISSARIAT A L'ENERGIE ATOMIQUE, 75015 Paris (FR)
(72) Inventeur: Danroc, Joel, 38100 Grenoble (FR); Juliet, Pierre, 38100 Grenoble (FR); Rigal, Emmanuel, 38000 Grenoble (FR); Schuster, Frédéric, 38000 Grenoble (FR)
(74) Mandataire: Dubois-Chabert, Guy

(57) **Abrégé**

Un dispositif pour réaliser un dépôt par pulvérisation cathodique magnétron, comporte des moyens (20,22) pour diriger un faisceau d'électrons sur une cible (8) d'un matériau à déposer sur un substrat (10), afin de chauffer cette cible.

Application aux barrières thermiques résistant à la corrosion et aux chocs thermiques.

## Description

### Domaine technique et art antérieur

L'invention concerne la technique de dépôt par pulvérisation cathodique magnétron, à partir d'une cible. Elle trouve une application particulièrement intéressante dans le cas d'une cible comportant un composé de zirconium.

En effet, la zircone, de par ses propriétés de conducteur ionique et d'isolant thermique est un matériau à très large champ d'applications industrielles, surtout lorsqu'elle est stabilisée :
- dans sa phase quadratique :la zircone partiellement stabilisée présente une bonne résistance aux chocs thermiques et trouve des applications en tant que dépôt pour chambre de combustion,
- ou dans sa phase cubique :elle est alors complètement stabilisée, et elle trouve des applications à plus haute température, avec moins de sollicitations en cyclage thermique.

La possibilité de faire des revêtements de surface avec ce matériau élargit encore le domaine d'application, car elle permet de conférer les propriétés spécifiques énoncées ci-dessus à la surface de matériaux communs.

Pour les applications de barrière thermique, des revêtements d'épaisseur comprise entre 100 et 500 µm sont convenables.

La technologie la plus couramment utilisée pour réaliser de tels dépôts est la projection thermique d'une poudre, par torche à plasma. Ce type de revêtement donne satisfaction en ce qui concerne la formation de la barrière thermique, et peut être appliqué sur des pièces de géométrie complexe. Par contre, du fait de leur porosité, les dépôts obtenus sont perméables à l'oxygène, ce qui entraîne une corrosion sous-jacente du substrat. Il peut en résulter le décollement du revêtement lors de cyclages ou de chocs thermiques.

Pour ces raisons, d'autres technologies ont été développées, en particulier les dépôts en phase vapeur. D'une manière générale, ces technologies conduisent à des dépôts denses et adhérents, et donc de tenue aux chocs thermiques et à la corrosion supérieure aux matériaux obtenus par projection à chaud. Deux méthodes de dépôts sous vide ont été développées : la pulvérisation cathodique et l'évaporation par bombardement électronique.

La pulvérisation cathodique magnétron met en oeuvre un plasma de décharge confiné magnétiquement près de la surface de la cible. Elle peut se faire en courant continu, avec une cible métallique sous pression partielle d'oxygène, ou en mode radiofréquence. Dans tous les cas, les vitesses de dépôt sont de l'ordre de quelques µm par heure au mieux. Ces vitesses sont difficilement compatibles avec les épaisseurs (100 à 300 µm) utilisées dans les fonctions de barrière thermique.

Par ailleurs, la pulvérisation radiofréquence, est, à cause des difficultés d'accord d'impédance, très mal adaptée au traitement des pièces complexes. Enfin, si la voie réactive est plus souple, elle implique, notamment dans le cas de la zircone, l'utilisation de cibles métalliques convenablement dopées, ou d'installation de copulvérisations complexes, pour obtenir la concentration en éléments stabilisants voulue.

Dans tous les systèmes magnétrons, on s'efforce de refroidir la cible afin de protéger de la désaimantation les circuits magnétiques situés derrière la cathode, et de limiter la dégradation des cibles.

L'évaporation par bombardement électronique est, quant à elle, convenable en ce qui concerne la vitesse de dépôt. Par contre, et comparativement aux techniques de pulvérisation, elle présente certaines limites. En particulier, l'adhérence des couches obtenues, ainsi que leurs propriétés mécaniques, sont généralement moindres, sauf si on utilise une assistance par plasma. En outre, il faut opérer généralement sous un vide plus poussé qu'en pulvérisation. Le dépôt ne peut se faire qu'en configuration verticale, le substrat étant situé au-dessus de la source. Par ailleurs, la directivité marquée de l'évaporation n'est pas adaptée aux pièces de géométrie complexe. Cette technique présente de plus des difficultés d'exploitation au défilé et le contrôle de la coévaporation est délicat. Enfin, il est impossible de faire des dépôts dans des alésages.

Toutes ces caractéristiques sont très limitatives pour des applications industrielles très larges de l'évaporation par bombardement électronique.

### Exposé de l'invention

L'invention vise à proposer un dispositif et un procédé pour réaliser des dépôts par pulvérisation cathodique magnétron, permettant d'obtenir des conditions de décharge magnétron stables en courant continu ou en courant pulsé, en particulier dans le cas d'une cible de zircone. L'invention doit de préférence permettre d'obtenir des dépôts denses et adhérents, contrairement à ceux obtenus en projection thermique, ainsi que des vitesses de dépôt élevées, contrairement à la pulvérisation radiofréquence. Par ailleurs, elle doit être mieux adaptée que la pulvérisation radiofréquence et que l'évaporation pour faire des dépôts sur des pièces complexes (la pulvérisation RF pose des problèmes d'accord d'impédance, tandis que l'évaporation est fortement directive). Elle doit, de préférence permettre d'obtenir des revêtements constituant des barrières thermiques de haute performance, en ce qui concerne la résistance à la corrosion et la tenue aux chocs thermiques, en particulier dans le cas de dépôt de zircone.

De manière plus précise, l'invention a pour objet un dispositif pour réaliser un dépôt par pulvérisation cathodique magnétron, comportant des moyens pour diriger un faisceau d'électrons sur une cible d'un matériau à déposer afin de chauffer celle-ci.

Le fait de chauffer la cible et de la porter à haute température (par exemple : T≥600°C, ou 700°C, ou 900°C) diminue l'énergie de liaison dans le matériau de la cible. Il en résulte une augmentation du taux de pulvérisation et, donc, de la vitesse de dépôt. Les dépôts obtenus sont denses et adhérents, contrairement à ceux obtenus en projection thermique. La position de la cible est indifférente, d'où une certaine souplesse dans la conception des installations, contrairement à la technique d'évaporation. De même, toujours par rapport à la technique d'évaporation, les dépôts obtenus sont homogènes dans toute la zone des substrats située en vue directe de la cathode, qui présente une grande surface d'émission. Il est en outre aisé de contrôler le flux de vapeur, lequel est généralement très stable. Par ailleurs, il est possible d'effectuer des dépôts dans des alésages, ainsi que de contrôler étroitement les caractéristiques des couches déposées en jouant sur les paramètres de fonctionnement.

Le dispositif peut mettre en oeuvre une configuration magnétron plane. La cathode du magnétron est alors une surface plane. La cible est de préférence soit une plaque mince, de quelques millimètres d'épaisseur, constituée du matériau à pulvériser, soit un dépôt de ce matériau réalisé par projection thermique sur la cathode.

De même, le dispositif peut mettre en oeuvre une configuration magnétron cylindrique. Cette configuration peut être de type "post" (c'est-à-dire avec une cathode cylindrique destinée à être entourée par le substrat sur lequel le dépôt doit être effectué) ou de type "hollow" (c'est-à-dire avec une cathode cylindrique creuse, renfermant le ou les substrats à revêtir).

Des moyens peuvent être prévus pour assurer un mouvement de balayage du faisceau d'électrons sur la surface de la cible : ceci permet d'obtenir un chauffage homogène de cette surface.

En outre, une électrode secondaire peut être prévue, ainsi que des moyens pour diriger le faisceau d'électrons vers cette électrode : lorsqu'une température convenable de la cible est atteinte, le faisceau d'électrons est dirigé vers l'électrode secondaire, que l'on polarise positivement. Au cours de la pulvérisation, si la puissance de décharge ne suffit pas à maintenir la température de la cible dans un domaine convenant à la stabilité du plasma, on redirige momentanément le faisceau d'électrons sur la cible.

Des moyens de contrôle de la température de la cible peuvent être prévus. Ainsi, la mesure de la température de la cible peut être par exemple assurée par un pyromètre ou par un élément thermocouple convenablement isolé électriquement.

L'invention concerne également un procédé pour réaliser un dépôt, sur un substrat, par pulvérisation cathodique magnétron, le matériau à pulvériser étant déposé sur une cible, et ce procédé comportant :
- une étape préalable de chauffage de la cible, à l'aide d'un faisceau d'électrons,
- une étape de pulvérisation du matériau.

Ce procédé permet de résoudre les problèmes et présente les avantages expliqués ci-dessus en liaison avec le dispositif selon l'invention.

Le faisceau d'électrons peut, après chauffage, être dirigé sur une anode secondaire polarisée positivement, de manière à travers le flux de vapeur du magnétron.

Enfin, le procédé peut mettre en oeuvre une étape de contrôle de la température de la cible.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- les figures 1A et 1B représentent un mode de réalisation de l'invention, avec un chauffage de la cible par bombardement électronique,
- les figures 2A à 5B représentent divers mode de fonctionnement d'un dispositif selon l'invention.

### Description détaillée de modes de réalisation de l'invention

Le dispositif qui va être décrit est installé dans une enceinte, non représentée sur les figures, munie d'un groupe de pompage et des diverses servitudes rencontrées ordinairement dans les installations de dépôts sous vide. De manière classique, ce dispositif comporte une cathode, des moyens magnétiques pour établir le champ nécessaire au niveau de la cible, un substrat sur lequel le dépôt est à réaliser. La cathode est mise sous tension à l'aide de moyens de mise sous tension appropriés. Les substrats seront représentés dans les positions ordinaires qu'ils occupent dans les installations classiques de pulvérisation cathodique magnétron, c'est-à-dire en général en vue directe de la cathode, en favorisant si possible les incidences normales de la vapeur.

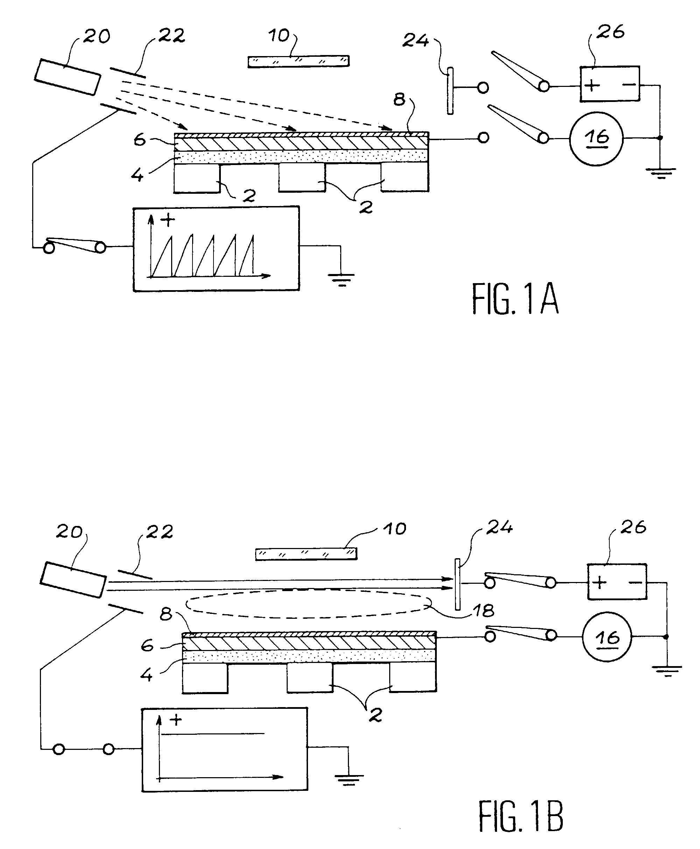

Sur les figures 1A et 1B, des références numériques identiques y désignent les mêmes éléments.

Conformément aux figures 1A et 1B, une configuration magnétron plan est mise en oeuvre. Le dispositif comporte une semelle conductrice ou cathode 6, plane, ainsi qu'un circuit magnétique 2 constitué d'aimants permanents à forte intensité. Ces aimants sont convenablement refroidis à l'aide d'un circuit de refroidissement adapté, et ils sont isolés thermiquement de la cathode 6 par un isolant thermique 4, afin que leur température ne dépasse pas le point de Curie. Il est également possible de remplacer les aimants permanents par une bobine magnétique, située à distance de la cathode 6, auquel cas la couche d'isolant thermique 4 n'est plus forcément nécessaire.

Sur la cathode 6 est déposée une cible 8. Celle-ci peut être une plaque mince (quelques mm d'épaisseur) du matériau à pulvériser, préparée par les technologies classiques de la céramique, et fixée sur la cathode 6. La cible peut également être constituée par un dépôt du matériau à pulvériser, ce dépôt étant réalisé par projection thermique sur la cathode 6.

Un substrat 10 sur lequel le matériau de la cible 8 doit être déposé est situé en regard de l'ensemble constitué par la cathode et la cible.

Des moyens, non représentés sur la figure, pour mesurer la température de la cible 8, peuvent être prévus, par exemple un pyromètre.

Le chauffage de la cible est réalisé par bombardement électronique. A cette fin, une source à électrons 20 est prévue, par exemple un canon à électrons, une cathode creuse ou tout autre dispositif émetteur d'électrons. Son faisceau peut être défléchi par un bobinage magnétique ou par des moyens 22 de déflexion électrostatique, ou bien il peut être dirigé géométriquement sur la cible. Cette dernière joue alors le rôle d'anode. Pour chauffer la cible, un faisceau d'électrons est dirigé sur cette dernière et peut être animé d'un mouvement de balayage lorsque l'on veut obtenir un chauffage homogène : à cette fin, une tension variable peut être appliquée aux moyens 22 de déflexion.

Lorsque la température convenable de la cible 8 est atteinte (pour la zircone : T > 700°C ou 900°C), cette dernière est polarisée négativement pour établir le plasma 18 de décharge (figure 1B), à l'aide d'une source de tension 16 (continue, ou moyenne fréquence, ou pulsée). Le faisceau d'électrons est alors dirigé sur une anode secondaire 24 que l'on polarise positivement avec des moyens 26. Le faisceau traverse alors le flux de vapeur en ionisant celle-ci, ce qui provoque une diminution de l'impédance du plasma 18 et une baisse de la tension nécessaire à la décharge. Si, au cours de la décharge, la puissance de décharge ne suffit pas à maintenir la température de la cible dans un domaine convenant à la stabilité du plasma 18, le faisceau d'électrons peut être momentanément redirigé sur la cible.

Il est également possible de simplement couper l'alimentation de la source 20 d'électrons.

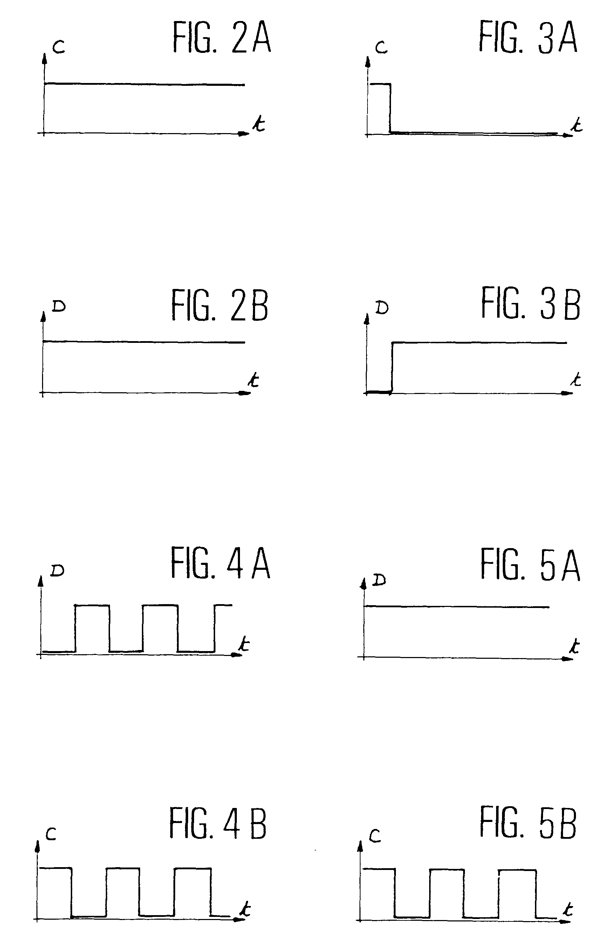

Plusieurs régimes de fonctionnement sont possibles, qui sont illustrés schématiquement sur les figures 2A à 5B.

Dans le cas du fonctionnement continu, on maintient continûment la puissance de chauffage C (figure 2A) pendant la décharge D (figure 2B).

Dans le cas du fonctionnement déclenché, le chauffage de la cible n'a lieu que lors du démarrage du procédé (figure 3A), la décharge, une fois établie, étant suffisante pour maintenir la cible à la température convenable : la décharge a lieu après chauffage (figure 3B).

Dans le cas du fonctionnement alterné, le chauffage (figure 4A) et la décharge (figure 4B) fonctionnent de manière alternée : la cible est périodiquement réchauffée après interruption périodique de la décharge.

Dans le cas du mode de fonctionnement séquencé, il y a chauffage périodique de la cible (figure 5A) sans interruption de la décharge (figure 5B).

L'utilisation de ce dispositif est particulièrement intéressante dans le cas d'une cible de zircone : la zircone devient conductrice électronique au-dessus de 900°C (pour les dépôts, cette valeur est ramenée à 700°C) . Portée à cette température, la cible de zircone permet de maintenir des conditions de décharge magnétron stables en courant continu, ou en courant alternatif moyenne fréquence (40 à 350 kHertz) ou en courant pulsé. De manière plus précise, les matériaux déposés peuvent être par exemple les suivants :
- zircone stabilisée avec divers stabilisants :
   * stabilisants classiques MgO, CaO, Y₂O₃
   * stabilisants plus évolués : La₂O₃, Dy₂O₃, Er₂O₃
- mélange : ZrO₂-HfO₂ ou ZrO₂-Ce₂O₃.

Avec une cible de zircone, le dispositif et le procédé selon l'invention permettent d'obtenir des conditions de décharge magnétron stables, en courant continu, ou pulsé.

Le dispositif et le procédé selon l'invention permettent d'obtenir des dépôts denses et adhérents.

Le fait d'obtenir des dépôts denses, donc imperméables à l'oxygène, permet leur emploi dans des applications où la tenue à la corrosion et aux chocs thermique est recherchée, notamment en aéronautique.

L'invention permet de plus d'obtenir des revêtements pour des barrières thermiques de haute performance en ce qui concerne la résistance à la corrosion et la tenue aux chocs thermiques. Par ailleurs, les dépôts réalisés ont de bonnes propriétés mécaniques, et leur état de surface est celui du substrat. Les dépôts obtenus ont donc une fonctionnalité anti-usure.

Leurs bonnes propriétés mécaniques permettent aux dépôts obtenus d'être utilisé dans des applications anti-usure, par exemple pour des contacts mécaniques à haute température.

L'invention permet d'utiliser des matières premières issues des filières industrielles ordinaires, telles que les poudres d'oxyde fritté ou projeté, ce qui est un avantage considérable par rapport à la pulvérisation réactive.

Il est possible d'utiliser, quelle que soit la configuration envisagée, plusieurs cibles de nature différente dans une installation de copulvérisation, ou bien des cibles composites, et d'ajuster ainsi la composition du dépôt.

L'invention est mieux adaptée que la pulvérisation radiofréquence ou que la technique d'évaporation pour faire des dépôts sur des pièces complexes.

Le dispositif magnétron plan est couramment utilisé pour faire des dépôts au défilé sur des pièces de dimensions finies ou infinies (par exemple des rouleaux de tôle). La vitesse de dépôt élevée obtenue grâce au dispositif monté sur une installation convenable permet de faire des revêtements d'oxyde au défilé.

Deux exemples de dépôt réalisés vont maintenant être donnés.

### EXEMPLE 1

La configuration utilisée est celle d'un magnétron plan de taille 210mmx90mm. Le système de chauffage utilisé est une cathode creuse, dont l'axe est parallèle au grand axe de la cathode magnétron et incliné de 30° par rapport au plan de la cathode. L'orifice de la cathode creuse est situé à l'aplomb du bord de la cathode magnétron. La température de la cible est mesurée par un pyromètre. Un substrat de molybdène est placé parallèlement à la cathode magnétron à une distance de 70 mm.

La cible est constituée d'une plaque de cuivre recouverte d'un dépôt de zircone partiellement stabilisée, effectué par projection plasma. L'épaisseur du dépôt est de 300 µm. La composition choisie est ZrO₂-7% Y₂O₃.

Lors de la première phase, la cathode creuse est démarrée et délivre un courant d'électrons de 5 A avec une énergie de 500 eV pour un débit d'argon de 10 cm³/mn. La surface de la cible parvient, au bout de quelques minutes, à une température de 800 à 900°C. On démarre alors l'alimentation à courant continu de la cathode magnétron, en augmentant le débit de gaz jusqu'à une pression de 0,5 Pa. La décharge continue s'établir de façon stable. Une puissance de décharge de 2000 W est établie sous une tension de 300 à 400 volts, plus basse que la tension ordinaire d'un magnétron : la baisse d'impédance du plasma est provoquée par l'injection des électrons de la cathode creuse.

Après une demi-heure de fonctionnement, la décharge, toujours stable, est arrêtée, et la cathode creuse désactivée. On obtient alors, sur le substrat, une couche isolante de 10 µm d'épaisseur. Une analyse sommaire de la couche à la microsonde électronique montre la présence de zirconium, d'yttrium et d'oxygène dans des proportions compatibles avec la stoechiométrie de la zircone partiellement stabilisée.

### EXEMPLE 2

La configuration utilisée est celle d'un magnétron plan alimenté en courant continu. La taille de la cathode est de 350mmx100 mm. Un canon à électron est placé parallèlement au grand axe de la cathode. La sortie des électrons se fait à l'aplomb du bord de la cathode. Au niveau de la sortie des électrons, sont installées deux paires de plaques polarisées par deux tensions de forme triangulaires et asynchrones; Le but de ce système est de balayer le faisceau d'électrons sur toute la surface de la cathode pour obtenir un chauffage homogène. La puissance du canon à électrons est de l'ordre de grandeur de 10 KW, l'énergie des électrons étant ajustable entre 500 et 10000 eV. A l'autre extrémité de la cathode, une plaque collectrice refroidie et polarisable positivement est installée.

Une cible de zircone de quelques millimètres d'épaisseur est fixée sur la cathode magnétron. Cette cible est dans le cas de l'exemple présenté, obtenue par frittage. Des résultats concluants ont également été obtenus avec une cible élaborée par des techniques de projection thermique. Le substrat est situé parallèlement à la cathode, à une distance de 80 mm. Il est polarisé par une tension radiofréquence (13.56 MHz). La tension de polarisation est ajustable entre -50 et -300 V.

On démarre tout d'abord le canon à électrons avec une puissance de 10 KW. Au bout de quelques secondes, la cible devient conductrice et il est possible de démarrer l'alimentation courant continu de la cathode magnétron, et d'établir un plasma de décharge stable en injectant de l'argon jusqu'à une pression de 1 Pa. La tension de la cathode est alors de l'ordre de 500 V. L'alimentation du dispositif de balayage du faisceau d'électrons est coupée, et l'anode refroidie est alors polarisée positivement. Les électrons traversent alors le plasma de décharge ; leur effet est d'ioniser le flux de vapeur en formant des ions Zr⁺ et O⁺. La tension de polarisation du substrat permet d'accélérer ces ions et de former un dépôt dense et, surtout, adhérent.

Dès que la tension de décharge commence à augmenter, indiquant une diminution de la conductivité de la cible, on réactive les plaques de balayage durant quelques secondes pour réchauffer la cible et restabiliser la décharge. On revient ensuite à la configuration dans laquelle l'anode est polarisée et la vapeur ionisée.

Les dépôts obtenus présentent les caractéristiques suivantes :
- pour une puissance de décharge de 1 KW, la vitesse de dépôt est de 0,1 µm/mn,
- une analyse aux rayons X révèle clairement les phases cristallines de la zircone,
- l'utilisation de l'anode auxiliaire, pour ioniser la vapeur, produit une augmentation significative de l'adhérence. En effet, un test de rayure réalisé sur des dépôts obtenus sans activation de l'anode auxiliaire conduit à des charges critiques de 30 N. Si l'anode auxiliaire est activée, celle-ci dépasse les 60 N.

## Revendications

1. Dispositif pour réaliser un dépôt par pulvérisation cathodique magnétron comportant des moyens (20, 22) pour chauffer une cible (8) d'un matériau à déposer, ces moyens pour chauffer la cible comportant des moyens (20, 22) pour diriger un faisceau d'électrons sur la cible (8).

2. Dispositif selon la revendication 1, les moyens pour chauffer la cible permettant d'atteindre une température de la cible d'au moins 600°C.

3. Dispositif selon l'une des revendications 1 ou 2, comportant en outre des moyens de mesure de la température de la cible.

4. Dispositif selon l'une des revendications 1 à 3, mettant en oeuvre une configuration magnétron plane.

5. Dispositif selon l'une des revendications 1 à 4, comportant en outre des moyens (22) pour assurer un mouvement de balayage du faisceau d'électrons.

6. Dispositif selon l'une des revendications 1 à 5, comportant en outre une électrode secondaire (24), et des moyens pour diriger le faisceau d'électrons vers cette électrode.

7. Procédé pour réaliser un dépôt par pulvérisation cathodique magnétron, sur un substrat (10), le matériau à pulvériser étant déposé sur une cible (8), ce procédé comportant :
- une étape de chauffage préalable de la cible, par un faisceau d'électrons,
- une étape de pulvérisation du matériau.

8. Procédé selon la revendication 7, le faisceau d'électrons étant, après chauffage, dirigé sur une anode secondaire (24) polarisée positivement, de manière à traverser le flux de vapeur du magnétron.

9. Procédé selon l'une des revendications 7 ou 8, le matériau à déposer étant de la zircone stabilisée.

10. Procédé selon la revendication 9, le stabilisant étant choisi parmi MgO, CaO, Y₂O₃, La₂O₃, Dy₂O₃, Er₂O₃.

11. Procédé selon l'une des revendications 7 ou 8, le matériau à déposer étant un mélange ZrO₂-HfO₂ ou ZrO₂-Ce₂O₃.
